# EUROPÄISCHE PATENTSCHRIFT

(11) **EP 0 285 597 B1**
(45) Veröffentlichungstag und Bekanntmachung des Hinweises auf die Patenterteilung: **16.06.1993**
(21) Anmeldenummer: 88890054.5
(22) Anmeldetag: 15.03.1988
(51) Int. Cl.: B44B 5/00, B44B 5/02, B21C 51/00

(54) **Vorrichtung zum Einprägen verschiedener Stempelzeichen in ein Walzprofil**
Device for embossing different die stamping signs in a rolled steel section
Dispositif pour l'emboutissage de plusieurs signes d'estampage dans un profilé

(30) Priorität: 01.04.1987 AT 789/87
(43) Veröffentlichungstag der Anmeldung: 05.10.1988
(73) Patentinhaber: Stangl, Kurt, Dipl.-Ing., A-4844 Regau Nr. 106 (AT)
(72) Erfinder: Stangl, Kurt, Dipl.-Ing., A-4844 Regau Nr. 106 (AT)
(74) Vertreter: Hübscher, Heiner, Dipl.-Ing.

(56) Entgegenhaltungen:
- EP-A- 0 019 027
- DE-A- 3 122 392
- FR-A- 2 239 095
- GB-A- 2 078 151

## Beschreibung

Die Erfindung bezieht sich auf eine Vorrichtung zum Einprägen verschiedener Stempelzeichen in ein Walzprofil mit einem am Walzprofil abwälzbaren Stempelkopf, der um eine zur Laufrichtung des Walzprofiles senkrechte und zur Stempelfläche parallele Achse drehbar in einem quer zur Stempelfläche anstellbaren Schlitten gelagert ist und die für eine Stempelung vorgesehenen Stempelzeichen entlang einer Wälzbahn trägt.

Bei Stempelvorrichtungen mit einem am Walzprofil abwälzbaren Stempelkopf, mit dessen Hilfe die Stempelzeichen beim Abwälzvorgang in das Stempelgut eingeprägt werden, kann zwar die Einprägung der Stempelzeichen in einer für das Stempelgut schonenden Weise durchgeführt werden, doch eignen sich die bekannten Vorrichtungen dieser Art nicht für das Einprägen von sich von Stempelung zu Stempelung ändernden Zeichensätzen, wie sie beispielsweise für die Stempelung von fortlaufenden Zahlen erforderlich sind.

Um Zeichensätze von Stempelung zu Stempelung ändern zu können, ist es bekannt (DE-A 3 122 392), die Stempelzeichen auf um eine gemeinsame Achse drehverstellbaren Rädern vorzusehen, die je einen Satz von verschiedenen Stempelzeichen tragen, so daß durch eine Drehverstellung dieser Stempelräder die gewünschten Stempelzeichen in die Stempellage gedreht werden können. Die Stempelräder sind in einem quer zur Lagerachse der Stempelräder verstellbaren Schlitten gelagert, der zum Einprägen der ausgewählten Stempelzeichen in das metallische Werkstück gegen dieses gedrückt wird. Die im Schlitten angeordneten Stempelräder schließen jedoch ein Einprägen der Stempelzeichen während eines Abwälzvorganges aus.

Schließlich ist es bekannt (GB-B 2 078 151), verschiedene Stempelzeichen radial verschiebbar in einem Stempelrad zu lagern, das auf dem Stempelgut abgewälzt wird. Da einzelne der Stempelzeichen ausgewählt und in eine Stempellage radial auswärt verschoben werden können, kann das Stempelgut mit verschiedenen Zeichensätzen gestempelt werden. Es ist allerdings nicht möglich, das an einer Umfangsstelle vorgesehene Stempelzeichen durch ein anderes Zeichen zu ersetzen, wie dies für die Stempelung von fortlaufenden Zahlen erforderlich wäre, deren Ziffernabstand vorgegeben ist.

Der Erfindung liegt somit die Aufgabe zugrunde, eine Vorrichtung zum Einprägen verschiedener Stempelzeichen in ein Walzprofil der eingangs geschilderten Art so zu verbessern, daß die einzelnen für eine Stempelung vorgesehenen Stempelzeichen zwischen den Stempelungen einfach wahlweise durch ein anderes Stempelzeichen aus einem Satz von Stempelzeichen ersetzt werden können.

Die Erfindung löst die gestellte Aufgabe dadurch, daß für die Stempelzeichen Zeichenträger vorgesehen sind, die im Stempelkopf um eine zur Drehachse des Stempelkopfes senkrechte, durch den Wälzbahnmittelpunkt gehende Achse drehverstellbar gelagert sind und je einen Satz von verschiedenen Stempelzeichen in einem vorgegebenen, auf ihre Lagerachse bezogenen Winkelabstand aufweisen, und daß den je für sich in Drehschritten entsprechend dem Winkelabstand zwischen den einzelnen Stempelzeichen verstellbaren Zeichenträgern eine lösbare Verriegelung im Stempelkopf zugeordnet ist.

Durch das Vorsehen von verstellbaren Zeichenträgern, die jeweils einen Satz verschiedener Stempelzeichen aufweisen, können die für eine Stempelung vorzusehenden Stempelzeichen beliebig durch eine entsprechende Verstellung der Zeichenträger zusammengesetzt werden. Die Lagerung der Zeichenträger auf einer im Stempelkopf vorgesehenen Lagerachse, die senkrecht zur Drehachse des Stempelkopfes verläuft und durch den Wälzbahnmittelpunkt geht, stellt dabei in einfacher Weise die für das Auswechseln der Stempelzeichen notwendige Querbewegung zur Wälzbahn sicher, und zwar unter Einhaltung eines ausreichenden Durchmessers der Zeichenträger, um nicht nur alle Zeichen des vorgesehenen Satzes von Stempelzeichen mit einem entsprechenden gegenseitigen Winkelabstand über den Umfang der Zeichenträger verteilt anbringen zu können, sondern auch ausreichend Platz für die Verriegelung der Zeichenträger in den verschiedenen Drehstellungen zu erhalten. Die Zeichenträger müssen ja nach ihrer Drehverstellung in dem Winkelabstand zwischen den einzelnen Stempelzeichen entsprechenden Drehschritten gegenüber dem Stempelkopf verriegelt werden, um die Lage der für eine Stempelung vorgesehenen Stempelzeichen auf der Wälzbahn des Stempelkopfes festlegen zu können.

Besonders einfache Konstruktionsverhältnisse ergeben sich für die Verriegelung der Zeichenträger in weiterer Ausbildung der Erfindung dann, wenn je ein verstellbar im Stempelkopf gelagerter, im Verriegelungssinn beaufschlagter Verriegelungskeil für die einzelnen Zeichenträger vorgesehen ist, die für jede Drehstellung eine gesonderte, radiale Verriegelungsausnehmung zur formschlüssigen Aufnahme des Verriegelungskeiles aufweisen. Durch das bezüglich der Lagerachse der Zeichenträger radiale Eingreifen der Verriegelungskeile in je eine der Verriegelungsausnehmungen der Zeichenträger wird eine Ausrichtung der einzelnen Zeichenträger gegenüber den Verriegelungskeilen erzwungen, wobei durch den Einsatz von Verriegelungskeilen eine spielfreie Verriegelung erzielt wird. Die Beaufschlagung der Verriegelungskeile durch Federn gewährleistet dabei einen sicheren Eingriff der Verriegelungskeile in den radialen Verriegelungsausnehmungen.

Die Verriegelungskeile könnten zwar in Gleitführungen des Stempelkopfes gehalten werden, doch ergeben sich vorteilhaftere Bedingungen, wenn die Verriegelungskeile auf federbelasteten Schwenkhebeln sitzen, die über eine gemeinsame Betätigungsleiste gegen die Federbelastung verschwenkbar sind. Zum Umrüsten des Stempelkopfes braucht folglich lediglich die gemeinsame Betätigungsleiste an die Schwenkhebeln angedrückt zu werden, um die Verriegelungskeile aus den Verriegelungsausnehmungen der Zeichenträger herausziehen und die Zeichenträger zur Einstellung eines neuen Zeichensatzes für die folgende Stempelung verdrehen zu können. Nach der Drehverstellung der Zeichenträger werden die einzelnen Schwenkhebeln durch die gemeinsame Betätigungsleiste freigegeben, so daß die Zeichenträger in der gewählten Drehstellung jeweils für sich mit Hilfe der in die Verriegelungsausnehmungen eingreifenden Verriegelungskeile im Stempelkopf verriegelt werden.

Die gemeinsame Entriegelung aller Zeichenträger über eine gemeinsame Betätigungsleiste bringt den Vorteil einer einfachen Betätigung mit sich. Dabei besteht jedoch die Gefahr, daß beim Verstellen eines Zeichenträgers ein benachbarter Zeichenträger ungewollt mitverstellt wird. Zur Vermeidung einer solchen fehlerhaften Verstellmöglichkeit der Zeichenträger können diese auf einer stempelkopffesten Lagerachse drehbar gelagert und durch drehfest mit der Lagerachse verbundene Trennringe voneinander getrennt werden. Diese Maßnahme stellt in einfacher Weise sicher, daß sich die Drehbewegung eines Zeichenträgers nicht auf einen benachbarten Zeichenträger übertragen kann.

Der Antrieb der Zeichenträger zum Einstellen der jeweils in das Stempelgut einzuprägenden Stempelzeichen kann auf dem Stempelkopf selbst angeordnet sein. Eine solche Konstruktion vergrößert jedoch die Stempelkopfmasse, was im Zusammenhang mit der erforderlichen Drehbeschleunigung des Stempelkopfes nachteilig ist, unabhängig davon, ob der Stempelkopf durch einen eigenen Antrieb auf die Laufgeschwindigkeit des Walzprofils beschleunigt oder durch das Stempelgut selbst mitgenommen wird. Aus diesem Grunde empfiehlt sich ein außerhalb des Stempelkopfes angeordneter Antrieb für die einzelnen Zeichenträger, was allerdings einen entsprechenden Ankuppelvorgang erfordert. Um hier vergleichsweise einfache Antriebsbedingungen zu schaffen, kann jedem mit einem Kettenrad verbundenen Zeichenträger ein im Führungsgestell für den Schlitten des Stempelkopfes angeordneter Kettentrieb zugeordnet werden, wobei die Kettenräder der Zeichenträger mittels des Schlittens an die Triebketten der Kettentriebe angestellt werden können. Zur Änderung des in das Walzprofil einzuprägenden Stempelzeichensatzes ist somit vor der nachfolgenden Stempelung der Stempelkopf mittels des Schlittens an die Kettentriebe anzustellen, so daß die Kettenräder der einzelnen Zeichenträger in die Triebketten der Kettentriebe eingreifen können. Über die Kettentriebe können dann nach einer Entriegelung der Zeichenträger die Zeichenträger in den vorgegebenen Drehschritten verstellt werden. Nach der Einstellung des für die folgende Stempelung erforderlichen Stempelzeichensatzes und der Verriegelung der Zeichenträger braucht der Stempelkopf über den Schlitten lediglich an das Stempelgut angestellt zu werden.

Der Eingriff der Kettenräder der einzelnen Zeichenträger in die Triebketten der zugehörigen Kettentriebe kann dadurch unterstützt werden, daß die mit den Kettenrädern kuppelbaren Trume der Triebketten auf einem federnd gelagerten Führungskamm abgestützt sind. Diese Abstützung der Triebkette stellt einen sicheren Eingriff der Zähne der Kettenräder in die Triebketten sicher, weil trotz der Abstützung der Triebkette eine Ausweichbewegung möglich ist, wenn beim Anstellen der Kettenräder an die Triebkette ein Zahn auf ein Kettengelenk auftrifft.

Um ein für das Stempelgut schonendes Aufsetzen des Stempelkopfes auf das Stempelgut zu ermöglichen und zugleich eine für die Einprägung der Stempelzeichen in die Stempelfläche ausreichende Anpreßkraft aufbringen zu können, kann der Radius der Wälzbahn des Stempelkopfes in einem den Stempelzeichen in Drehrichtung vorgelagerten Abschnitt gegen die Stempelzeichen hin abnehmen, so daß nach dem Aufsetzen des Stempelkopfes auf die Stempelfläche eine zusätzliche Anstellbewegung im Ausmaß der Abnahme des Wälzbahnradius bis zum eigentlichen Stempelvorgang notwendig wird. Durch diese zusätzliche Anstellbewegung kann die erforderliche Anpreßkraft ohne stoßartige Beanspruchung des Stempelgutes aufgebracht werden.

Ist mit einer unterschiedlichen Neigungslage der Stempelfläche zu rechnen, so muß für eine gleichmäßige Einprägetiefe der Stempelzeichen die Drehachse des Stempelkopfes parallel zur Stempelfläche ausgerichtet werden. Zu diesem Zweck kann der Stempelkopf um eine zur Laufrichtung des Walzprofiles parallele Tangente an die Wälzbahn schwenkbar im Schlitten gelagert sein. Die Wahl einer geometrischen Schwenkachse, die zur Laufrichtung des Walzprofiles parallel verläuft und die Wälzbahn tangiert, ist erforderlich, um durch das Schwenken keine Querverlagerung des Stempelkopfes in Kauf nehmen zu müssen. Zur konstruktiven Durchführung einer solchen Schwenklagerung des Stempelkopfes kann der Schlitten zur geometrischen Schwenkachse des Stempelkopfes koaxiale Führungen für das Drehlager des Stempelkopfes aufweisen. Bei einer Verstellung des Drehlagers des Stempelkopfes entlang dieser Führungen wird die gewünschte Neigungseinstellung des Stempelkopfes ermöglicht, ohne die Drehbarkeit des Stempelkopfes zu beeinträchtigen. Zur Festlegung der eingestellten Schwenklage kann das Drehlager für den Stempelkopf an den Führungen des Schlittens festgeklemmt werden, was eine stufenlose Neigungseinstellung für den Stempelkopf erlaubt.

Diese Klemmverbindung zwischen dem Drehlager für den Stempelkopf und dem Schlitten bringt außerdem den Vorteil einer spielfreien Halterung des Stempelkopfes im Schlitten mit sich, insbesondere dann, wenn das Drehlager mit Hilfe von beidseitig an die Führung anstellbaren Klemmbacken festgeklemmt wird, die in Schwenkrichtung des Stempelkopfes gegeneinander versetzt an der Führung angreifen, weil in diesem Fall über die Klemmbacken ein Drehmoment aufgebracht wird, das für eine Verspannung des Drehlagers gegenüber der Führung im Schlitten sorgt.

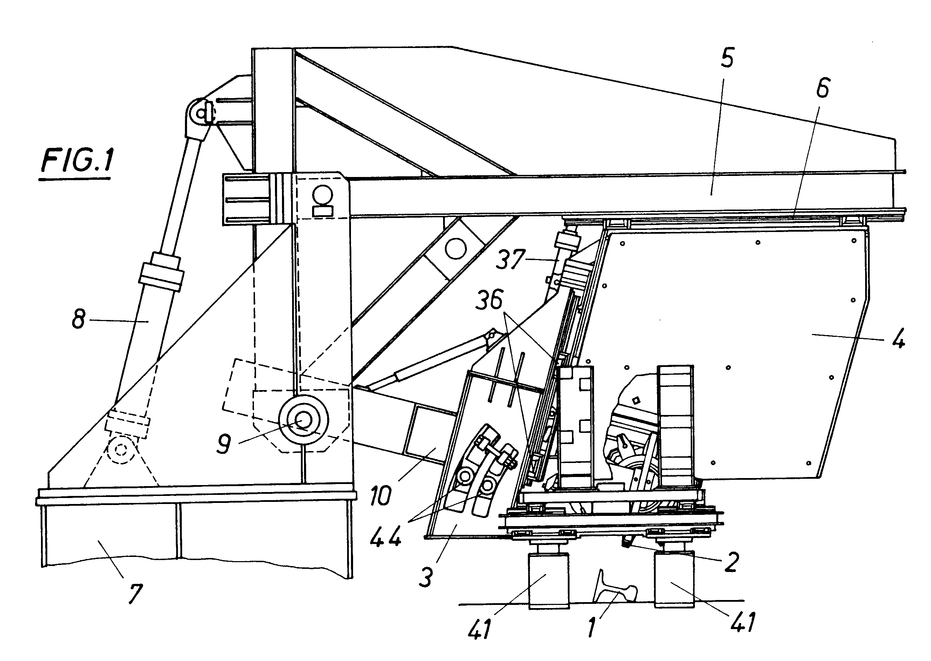

In der Zeichnung ist der Erfindungsgegenstand beispielsweise dargestellt. Es zeigen
- Fig. 1: eine erfindungsgemäße Vorrichtung zum Einprägen verschiedener Stempelzeichen in ein Walzprofil in einer vereinfachten, zum Teil aufgerissenen Ansicht in Laufrichtung des Stempelgutes,
- Fig. 2: den Stempelkopf dieser Vorrichtung in einer Ansicht in Laufrichtung des Stempelgutes in einem größeren Maßstab,
- Fig. 3: einen Schnitt nach der Linie III-III der Fig. 2,
- Fig. 4: den Stempelkopf in einer Ansicht in Richtung des Pfeiles IV der Fig. 2,
- Fig. 5: die Anordnung der Kettentriebe zum Verstellen der Zeichenträger des Stempelkopfes in einer schemattischen Seitenansicht und

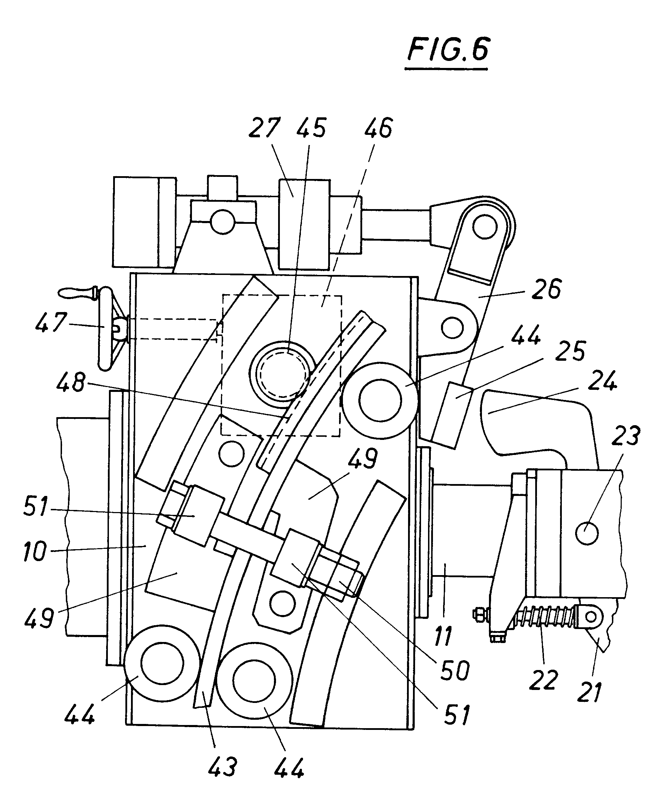

- Fig. 6: die Schwenklagerung des Drehlagers des Stempelkopfes in einer vereinfachten Seitenansicht unter Weglassung des Schlittens.

Die dargestellte Vorrichtung besteht im wesentlichen aus einem am Walzprofil 1 abwälzbaren Stempelkopf 2, der in einem quer zur Stempelfläche an das Walzprofil 1 anstellbaren Schlitten 3 drehbar gelagert ist, einem Führungsgestell 4 für den Schlitten 3 und einem Tragrahmen 5, der eine Gleitführung 6 für das Führungsgestell 4 aufweist und auf einem Fundament 7 schwenkbar gehalten wird, um die Vorrichtung vom Walzprofil 1 wegschwenken zu können. Zu diesem Zweck ist ein einerseits am Fundament 7 und anderseits am Tragrahmen 5 angelenkter Schwenkzylinder 8 vorgesehen, mit dessen Hilfe die Vorrichtung zwischen einer abgeschwenkten Arbeitsstellung und einer hochgeschwenkten Ruhestellung um die Schwenkachse 9 verstellt werden kann.

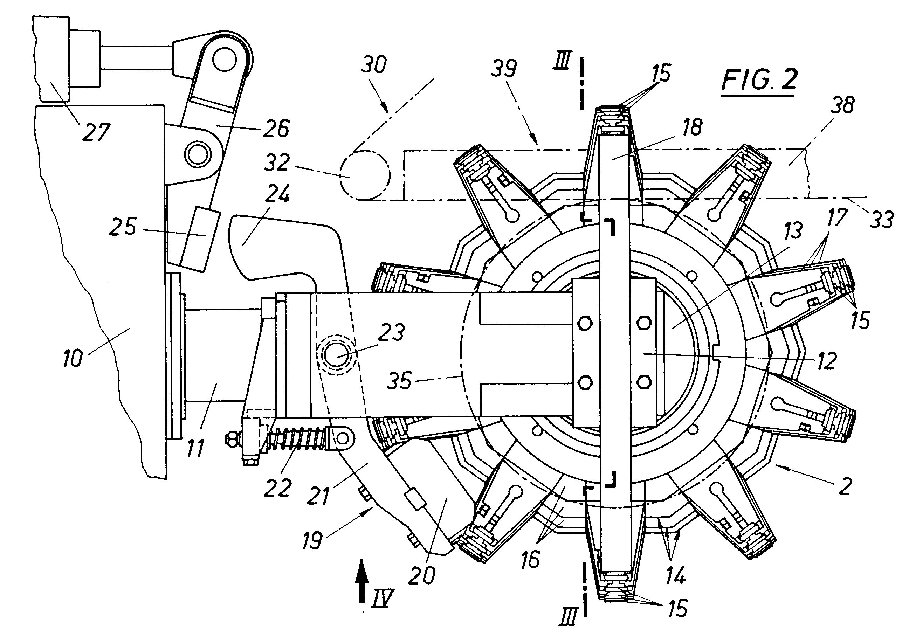

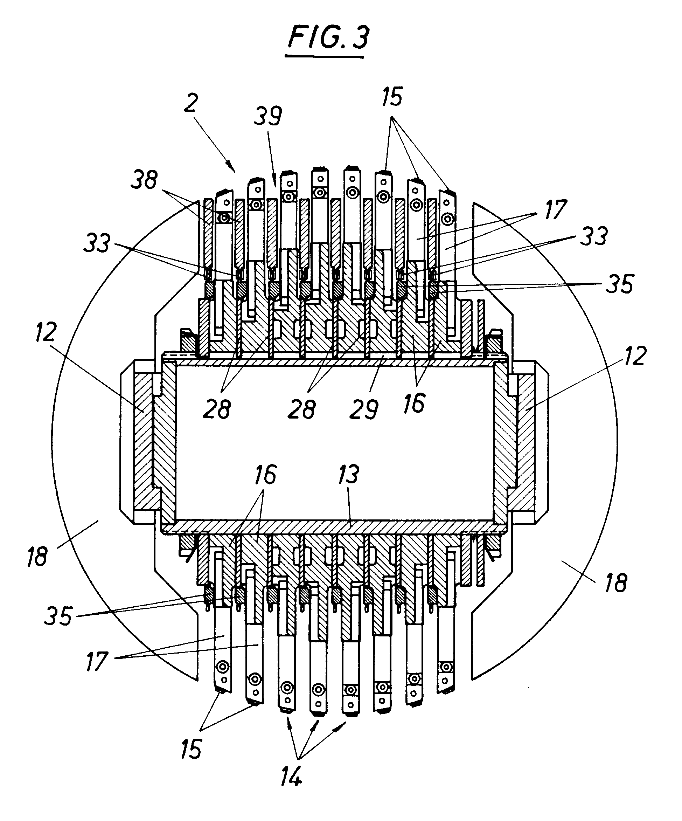

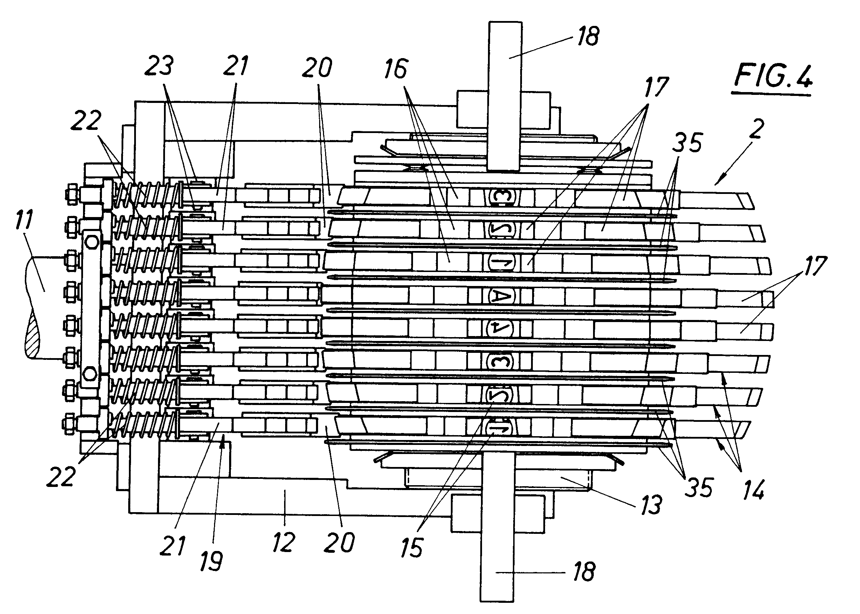

Der Stempelkopf 2 weist eine in einem Drehlager 10 gehaltene Drehachse 11 auf, die quer zur Laufrichtung des Walzprofiles 1 und parallel zur Stempelfläche des Walzprofiles ausgerichtet ist, so daß sich der Stempelkopf 2 mit dieser Drehachse 11 auf der Stempelfläche des Walzprofiles 1 abwälzen kann. Die Drehachse 11 bildet an ihrem stempelkopfseitigem Ende eine Lagergabel 12 für eine drehfest mit ihr verbundene, rohrförmige Lagerachse 13, auf der mehrere Zeichenträger 14 drehverstellbar gelagert sind. Diese Zeichenträger weisen jeweils einen Satz von verschiedenen Stempelzeichen 15 auf, die mit einem gleichmäßigen Winkelabstand über den Umfang der Zeichenträger 14 verteilt angeordnet sind, wie dies den Fig. 2 bis 4 entnommen werden kann. Die Anordnung ist dabei so getroffen, daß die einzelnen Stempelzeichen 15 von sternförmig an einem ringscheibenförmigen Grundkörper 16 angesetzten Armen 17 getragen werden, die in einer zur Drehachse 11 senkrechten Ebene durch die Lagerachse 13 die Wälzbahn für den Stempelkopf 2 bestimmen. Diese Wälzbahn wird durch an der Gabel 12 befestigte Rollsegmente 18 zur einer Umlaufbahn geschlossen, wie dies der Fig. 3 entnommen werden kann. Die Rollsegmente 18 weisen dabei in ihrem mittleren Bereich einen größeren Abstand von der Drehachse 11 als im Anschlußbereich an die Stempelzeichen 15 auf, die entlang eines Wälzkreises angeordnet sind. Da der Stempelkopf jeweils im Mittenbereich eines der beiden Rollsegmente 18 auf das Stempelgut aufgesetzt wird, muß während des Abwälzvorganges entlang der Rollsegmente 18 für eine zusätzliche Anstellbewgung des Stempelkopfes 2 an das Stempelgut gesorgt werden, was ein für das Stempelgut schonendes Aufbringen auch größerer, für eine ausreichende Einprägetiefe der Stempelzeichen 15 notwendiger Andrückkräfte erlaubt.

Um den für eine Stempelung vorgesehenen Stempelzeichensatz entlang der Wälzbahn ändern zu können, müssen die Zeichenträger 14 in Drehschritten verstellt werden, die dem Winkelabstand der Stempelzeichen 15 des an jedem Zeichenträger 14 vorgesehenen Zeichensatzes entsprechen, wobei die einzelnen Zeichenträger 14 in jeder ihrer Drehstellungen gegenüber dem Stempelkopf verriegelt werden müssen. Zu diesem Zweck ist eine Verriegelung 19 vorgesehen, die aus je einem zwischen den Armen 17 eingreifenden Verriegelungskeil 20 für die einzelnen Zeichenträger 14 besteht. Die Arme 17 der Zeichenträger 14 bilden somit die für die einzelnen Drehstellungen erforderlichen Verriegelungsausnehmungen zur formschlüssigen Aufnahme des zugehörigen Verriegelungskeiles 20, wobei sich der den einzelnen Drehschritten entsprechende Winkelabstand zwischen diesen Verriegelungsausnehmungen von selbst ergibt. Die Verriegelungskeile 20 sind jeweils auf gesonderten Schwenkhebeln 21 angeordnet, die über je eine Druckfeder 22 im Verriegelungssinn beaufschlagt werden, wie dies insbesondere aus der Fig. 2 hervorgeht. Die Schwenkhebel 21 bilden einen über die Anlenkachse 23 hinaus verlängerten Anschlagkopf 24 für eine gemeinsame Betätigungsleiste 25, die von einem Stellhebel 26 getragen wird, der über einen Zylinder 27 verstellt werden kann, so daß bei einer Beaufschlagung des Zylinders 27 alle Schwenkhebel 21 über die Betätigungsleiste 25 gegen die Kraft der Druckfedern 22 im Entriegelungssinn verstellt werden. Die somit durch die Verriegelungskeile 20 freigegebenen Zeichenträger 14 können zum Ändern des zu stempelnden Zeichensatzes in den vorgegebenen Drehschritten verstellt werden.

Damit bei der Drehverstellung eines Zeichenträgers 14 nicht ein benachbarter Zeichenträger 14 mitgenommen werden kann, sind zwischen den einzelnen Zeichenträgern 14 Trennringe 28 (Fig. 3) vorgesehen, die mit einem einspringenden Ansatz in eine Axialnut 29 der Lagerachse 13 eingreifen, so daß die Grundkörper 16 der Zeichenträger 14, nicht aber die Trennringe 28 gegenüber der drehfest in der Gabel 12 gehaltenen Lagerachse 13 verdreht werden können.

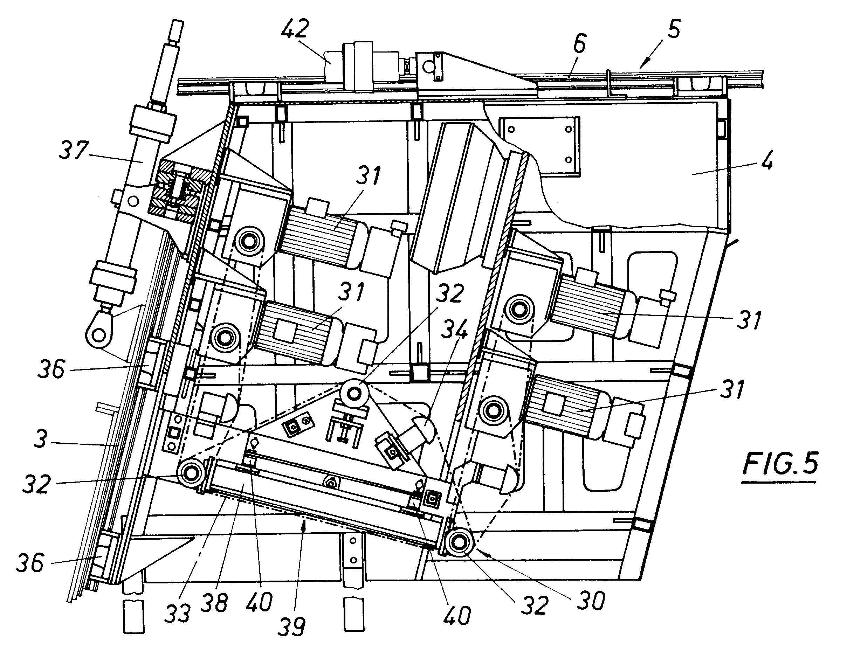

Die Drehverstellung der Zeichenträger 14 erfolgt von einem Antrieb her, der außerhalb des Schlittens 3 im Führungsgestell 4 für den Schlitten 3 angeordnet ist und aus je einem Kettentrieb 30 für die einzelnen Zeichenträger 14 besteht. Diese in Fig. 5 dargestellten, senkrecht zur Zeichenebene hintereinanderliegenden Kettentriebe 30, die jeweils für sich durch einen Motor 31 angetrieben werden können, weisen eine endlos über Umlenkräder 32 geführte Triebkette 33 auf, der eine übliche Spanneinrichtung 34 zugeordnet ist. Die Triebketten 33 wirken mit Kettenrädern 35 zusammen, die mit den einzelnen Zeichenträgern 14 verbunden sind. Wird nun in einer vorgegebenen Drehstellung des Stempelkopfes 2 der Schlitten 3 entlang der Führungen 36 des Führungsgestelles 4 verschoben, so tauchen die Triebketten 33 der Kettentriebe 30 zwischen den Zeichenträgern 14 in den Stempelkopf 2 ein, bis die Kettenräder 35 in die Triebketten 33 eingreifen, wie dies in den Fig. 2 und 3 angedeutet ist. Nach einem Lösen der Verriegelung 19 durch eine Beaufschlagung des Zylinders 27 können somit die einzelnen Zeichenträger 14 unabhängig voneinander über den zugehörigen Kettentrieb 30 verstellt werden, um ein gewünschtes Stempelzeichen 15 in die Wälzbahn zu drehen. Anschließend werden die Zeichenträger 14 durch eine Belüftung des Zylinders 27 wieder verriegelt, weil die Verriegelungskeile 20 in die Lücke zwischen den beiden ihnen zugeordneten Armen 17 der Zeichenträger 14 verschwenkt werden, und zwar über die Druckfedern 22, die ein spielfreies und formschlüssiges Eingreifen der Verriegelungskeile 20 in die Verriegelungsausnehmungen zwischen den Armen 17 sicherstellen. Mit Hilfe des Schlittens 3, der über den Stellzylinder 37 verfahren wird, kann dann der neu eingestellte Stempelkopf an das Stempelgut angestellt und die Stempelung durchgeführt werden.

Um beim Kuppeln der Kettenräder 35 mit den Triebketten 33 der Kettentriebe 30 ein unerwünschtes Nachgeben der Triebketten 33 zu vermeiden, können die mit den Kettenrädern 35 zusammenwirkenden Trume der Triebketten an parallelen Führungsleisten 38 eines Führungskammes 39 abgestützt werden, der für sich über Federkörper 40 gelagert ist, wie dies in Fig. 5 angedeutet wird.

Der Stempelkopf 2 kann quer zum Walzprofil 1 ausgerichtet werden, und zwar mit Hilfe von zwei Führungsrollen 41, die von beiden Seiten an das Walzprofil 1 angestellt werden können und eine Verschiebung des Führungsgestelles 4 für den Schlitten 3 entlang der Gleitführung 6 über eine Beaufschlagung des hiefür vorgesehenen Stellzylinders 42 (Fig. 5) steuern. Zusätzlich zu dieser Ausrichtung quer zum Walzprofil 1 kann der Stempelkopf 2 auch noch hinsichtlich seiner Neigung eingestellt werden, damit die Stempelzeichen senkrecht zur Stempelfläche in das Stempelgut eingeprägt werden können. Zu diesem Zweck weist der Schlitten 3 Führungen 43 in Form von Rollbahnen für Laufrollen 44 auf, die dem Drehlager 10 des Stempelkopfes zugeordnet sind. Da die Führungen 43 koaxial zu der in Laufrichtung des Walzprofiles 1 gerichteten Tangente an die Wälzbahn des Stempelkopfes 2 angeordnet ist, kann der Stempelkopf 2 bei einer Bewegung des Drehlagers 10 entlang der Führungen 43 gegenüber der Stempelfläche ohne Querverlagerung in seiner Neigung ausgerichtet werden. Zur Schwenkverstellung des Drehlagers 10 dient ein Ritzel 45, das über ein Getriebe 46 mittels eines Handrades 47 angetrieben werden kann und mit einer an den Führungen 43 vorgesehenen Zahnstange 48 kämmt. Ist die gewünschte Schwenklage des Stempelkopfes 2 erreicht, so wird das Drehlager 10 gegenüber dem Schlitten 3 festgeklemmt, und zwar mit Hilfe von zwei Klemmbacken 49, die schwenkbar am Drehlager 10 angelenkt und mit Hilfe von Spannschrauben 50, die an abstehenden Laschen 51 der Klemmbacken 49 angreifen, von entgegengesetzten Seiten an die Führungen 43 anpreßbar sind. Da diese Klemmbacken 49 in Verstellrichtung des Drehlagers 10 versetzt an den Führungen 43 angreifen, wird über die Klemmbacken 49 ein Drehmoment ausgeübt, das zu einer spielfreien Verspannung zwischen dem Schlitten 3 und dem Drehlager 10 führt.

## Patentansprüche

1. Vorrichtung zum Einprägen verschiedener Stempelzeichen (15) in ein Walzprofil (1) mit einem am Walzprofil (1) abwälzbaren Stempelkopf (2), der um eine zur Laufrichtung des Walzprofiles (1) senkrechte und zur Stempelfläche parallele Achse (11) drehbar in einem quer zur Stempelfläche anstellbaren Schlitten (3) gelagert ist und die für eine Stempelung vorgesehenen Stempelzeichen (15) entlang einer Wälzbahn trägt, dadurch gekennzeichnet, daß für die Stempelzeichen (15) Zeichenträger (14) vorgesehen sind, die im Stempelkopf (2) um eine zur Drehachse (11) des Stempelkopfes (2) senkrechte, durch den Wälzbahnmittelpunkt gehende Achse (13) drehverstellbar gelagert sind und je einen Satz von verschiedenen Stempelzeichen (15) in einem vorgegebenen, auf ihre Lagerachse (13) bezogenen Winkelabstand aufweisen, und daß den je für sich in Drehschritten entsprechend dem Winkelabstand zwischen den einzelnen Stempelzeichen (15) verstellbaren Zeichenträgern (14) eine lösbare Verriegelung (19) im Stempelkopf (2) zugeordnet ist.

2. Vorrichtung nach Anspruch 1, dadurch gekennzeichnet, daß die Verriegelung (19) für die Zeichenträger (14) aus je einem verstellbar im Stempelkopf (2) gelagerten, im Verriegelungssinn federbeaufschlagten Verriegelungskeil (20) für die einzelnen Zeichenträger (14) besteht, die für jede Drehstellung eine gesonderte, radiale Verriegelungsausnehmung zur formschlüssigen Aufnahme des Verriegelungskeiles (20) aufweisen.

3. Vorrichtung nach Anspruch 1 und 2, dadurch gekennzeichnet, daß die Verriegelungskeile (20) auf federbelasteten Schwenkhebeln (21) sitzen, die über eine gemeinsame Betätigungsleiste (25) gegen die Federbelastung verschwenkbar sind.

4. Vorrichtung nach einem der Ansprüche 1 bis 3, dadurch gekennzeichnet, daß die Zeichenträger (14) auf einer stempelkopffesten Lagerachse (13) drehbar lagern und daß zwischen den Zeichenträgern (14) drehfest mit der Lagerachse (13) verbundene Trennringe (28) angeordnet sind.

5. Vorrichtung nach einem der Ansprüche 1 bis 4, dadurch gekennzeichnet, daß jedem mit einem Kettenrad (35) verbundenen Zeichenträger (14) ein im Führungsgestell (4) für den Schlitten (3) des Stempelkopfes (2) angeordneter Kettentrieb (30) zugeordnet ist und daß die Kettenräder (35) der Zeichenträger (14) mittels des Schlittens (3) an die Triebketten (33) der Kettentriebe (30) anstellbar sind.

6. Vorrichtung nach Anspruch 5, dadurch gekennzeichnet, daß die mit den Kettenrädern (35) kuppelbaren Trume der Triebketten (33) auf einem federnd gelagerten Führungskamm (39) abgestützt sind.

7. Vorrichtung nach einem der Ansprüche 1 bis 6, dadurch gekennzeichnet, daß der Radius der Wälzbahn des Stempelkopfes (2) in einem den Stempelzeichen (15) in Drehrichtung vorgelagerten Abschnitt (Rollsegment 18) gegen die Stempelzeichen (15) hin abnimmt.

8. Vorrichtung nach einem der Ansprüche 1 bis 7, dadurch gekennzeichnet, daß der Stempelkopf (2) um eine zur Laufrichtung des Walzprofiles (1) parallele Tangente an die Wälzbahn schwenkbar im Schlitten (3) gelagert ist.

9. Vorrichtung nach Anspruch 8, dadurch gekennzeichnet, daß der Schlitten (3) zur geometrischen Schwenkachse des Stempelkopfes (2) koaxiale Führungen (43) für das Drehlager (10) des Stempelkopfes (2) aufweist.

10. Vorrichtung nach Anspruch 9, dadurch gekennzeichnet, daß das Drehlager (10) für den Stempelkopf (2) an den Führungen (43) festklemmbar ist.

11. Vorrichtung nach Anspruch 10, dadurch gekennzeichnet, daß das Drehlager (10) mit Hilfe von beidseitig an die Führungen (43) anstellbaren Klemmbacken (49) festklemmbar ist, die in Schwenkrichtung des Stempelkopfes (2) gegeneinander versetzt an der Führung (43) angreifen.

## Claims

1. A device for printing various stamped characters (15) on a rolled section member (1) and comprising a stamp head (2) rolling on the rolled section member (1) and mounted in a slide (3) adjustable transversely to the stamp surface so as to be rotatable around an axis (11) extending at right angles to the direction of motion of the rolled section member (1) and parallel to the stamp surface, the head carrying the characters (15) for stamping along a rolling path, characterised in that character holders (14) are provided for the stamped characters (15) and are mounted in the stamp head (1) so as to be adjustable by rotation around an axis (13) extending at right angles to the axis of rotation (11) of the stamp head (2) and through the centre of the rolling track, each holder comprising a set of different characters (15) at a preset angular distance relative to their axis (13), and a means (19) is provided in the stamp head (2) for releasably locking the character holders (14), which are each separately adjustable in rotary steps corresponding to the angular distance between the individual characters (15).

2. A device according to claim 1, characterised in that the means (19) for locking the character holders (14) comprises a wedge (20) for each individual character holder (14), the wedge being adjustably mounted in the stamp head (2) and spring-actuated in the locking direction, and the character holders having a separate radial locking recess for positively receiving the wedge (20) in each rotary position.

3. A device according to claims 1 and 2, characterised in that the wedges (20) rest on spring-loaded rocking levers (21) pivotable by a common actuating strip (25) against the spring bias.

4. A device according to any of claims 1 to 3, characterised in that the character holders (14) are mounted for rotation around an axis (13) stationary relative to the stamp head, and separating rings (28) non-rotatably connected to the axis (13) are disposed between the character holders (14).

5. A device according to any of claims 1 to 4, characterised in that a chain drive (30) disposed in the guide frame (4) for the slides (3) of the stamp head (2) is allocated to each character holder (14) connected to a sprocket wheel (35), and the sprocket wheels (35) of the character holders (14) can be set via the slide (3) against the chains (33) of the chain drives (30).

6. A device according to claim 5, characterised in that the runs of the chains (33) for coupling to the sprocket wheels (35) are mounted on a spring-mounted guide comb (39).

7. A device according to any of claims 1 to 6, characterised in that the radius of the rolling track of the stamp head (2) decreases towards the stamp characters (15) in a portion (roll segment 18) situated in front of the stamp characters (15) in the direction of rotation.

8. A device according to any of claims 1 to 7, characterised in that the stamp head (2) is mounted in the slide (3) so as to be pivotable around a tangent to the rolling track, parallel to the direction of motion of the rolled section member (1).

9. A device according to claim 8, characterised in that the slide (3) has guides (43) for the rotary bearing (10) of the stamp head (2), the guides being coaxial with the geometrical pivot axis of the stamp head (2).

10. A device according to claim 9, characterised in that the rotary bearing (10) for the stamp head (2) is adapted to be clamped to the guides (43).

11. A device according to claim 10, characterised in that the rotary bearing (10) is adapted to be clamped in jaws (29) adjustable against the guides (43) on each side, the jaws being offset from one another in the direction of pivoting of the stamp head (2) when they engage the guide (43).

## Revendications

1. Dispositif pour imprimer différents caractères de poinçons (15) dans un profilé laminé (1), comprenant une tête porte-poinçons (2) qu'on peut faire rouler sur le profilé laminé, qui est montée dans un chariot (3) qui peut être mis en pression transversalement à la surface des poinçons pour tourner autour d'un axe (11) perpendiculaire à la direction de défilement du profilé laminé (1) et parallèle à la surface des poinçons, et qui porte les caractères de poinçons (15) prévus pour un poinçonnage le long d'un trajet de roulement,
caractérisé par le fait qu'il est prévu pour les caractères de poinçons (15), des supports de caractères (14) qui sont montés pour être réglés en rotation autour d'un axe (13) perpendiculaire à l'axe de rotation (11) de la tête porte-poinçons (2), et qui passe par le centre du trajet de roulement, et présentent chacun un jeu de différents caractères de poinçons (15) à un écartement angulaire prédéterminé, rapporté à leur axe de montage (13), et par le fait qu'aux supports de caractères (14) qui peuvent se déplacer, séparément par pas angulaires correspondant à l'écartement angulaire entre les différents caractères de poinçons (15), est associé un verrouillage (19) déblocable monté dans la tête porte-poinçons (2).

2. Dispositif selon la revendication 1,
caractérisé par le fait que le verrouillage (19) agissant sur les supports (14) de caractères est constitué par un coin de verrouillage (20) monté mobile dans la tête porte-poinçons (2), et sollicité élastiquement dans le sens du verrouillage, qui agit sur les supports de caractères, lesquels présentent, pour chaque position de rotation, un évidement de verrouillage radial distinct, destiné à recevoir le coin de verrouillage (20) en établissant une liaison par sûreté de forme.

3. Dispositif selon la revendication 1 ou 2,
caractérisé par le fait que les coins de verrouillage (20) sont montés sur des leviers oscillants (231) sollicités élastiquement, qui peuvent pivoter à l'encontre de la sollicitation élastique, sous l'action d'une barre d'actionnement commune (25).

4. Dispositif selon une des revendications 1 à 3,
caractérisé par le fait que les supports de caractères (14) sont montés rotatifs sur un axe (13) solidaire de la tête porte-poinçons et par le fait qu'entre les supports de caractères (14), sont disposés des anneaux séparateurs (28) reliés rigidement en rotation à l'axe (13).

5. Dispositif selon une des revendications 1 à 4,
caractérisé par le fait qu'à chaque support de caractères (14) solidaire d'une roue à chaîne (35), est associé un entraînement de chaîne (30) disposé dans le bâti de guidage (4) du chariot (3) de la tête porte poinçons (2) et par le fait que les roues à chaînes (35) des supports de caractères (14) peuvent être rapprochées des chaînes d'entraînement (33) des entraînements à chaîne (30) au moyen du chariot (3).

6. Dispositif selon la revendication 5,
caractérisé par le fait que les brins des chaînes d'entraînement (33) qui peuvent être accouplés aux roues à chaîne (35) sont appuyés sur un peigne de guidage (39) monté élastiquement.

7. Dispositif selon une des revendications 1 à 6,
caractérisé par le fait que le rayon du trajet de roulement de la tête porte-poinçons (2) décroît en direction des poinçons (15), dans le segment (segment roulant 18) placé en amont des poinçons (15) dans le sens de la rotation.

8. Dispositif selon une des revendications 1 à 7,
caractérisé par le fait que la tête porte poinçons (2) est montée dans le chariot (3) pour pouvoir osciller autour d'une tangente au trajet de roulement qui est parallèle à la direction de défilement du profilé laminé (1).

9. Dispositif selon la revendication 8,
caractérisé par le fait que le chariot (3) présente des guides coaxiaux (43) pour le palier de rotation (10) de la tête porte-poinçons (2) qui sont coaxiaux à l'axe d'oscillation géométrique de la tête porte poinçons (2).

10. Dispositif selon la revendication 9,
caractérisé par le fait que le palier de rotation (10) de la tête porte-poinçons (2) peut être bloquée sur les guides (43).

11. Dispositif selon la revendication 10,
caractérisé par le fait que le palier de rotation (10) peut être bloqué au moyen de mâchoires de blocage (49) qui peuvent être rapprochées des guides (43) par les deux côtés, et qui attaquent le guide (43) dans des positions décalées l'une par rapport à l'autre dans la direction du pivotement de la tête porte-poinçons (2).
